# EUROPEAN PATENT APPLICATION

(11) **EP 3 001 783 A1**
(43) Date of publication of application: **30.03.2016**
(21) Application number: 13885129.0
(22) Date of filing: 20.05.2013
(51) Int. Cl.: H05K 3/46, H01L 23/12, H01L 23/28

(54) **COMPONENT-EMBEDDED SUBSTRATE AND MANUFACTURING METHOD FOR SAME**

(71) Applicant: Meiko Electronics Co., Ltd., Ayase-shi, Kanagawa 252-1104 (JP)
(72) Inventor: TODA, Mitsuaki, Ayase-shi Kanagawa 252-1104 (JP); MATSUMOTO, Tohru, Ayase-shi Kanagawa 252-1104 (JP); SHIMIZU, Ryoichi, Ayase-shi Kanagawa 252-1104 (JP)
(74) Representative: Epping - Hermann - Fischer
(86) International application number: PCT/JP2013/063959
(87) International publication number: WO 2014/188493

(57) **Abstract**

A device embedded substrate (1) includes: an insulating layer (3); a first metal layer (4) and a second metal layer (5) that are formed such that the insulating layer (3) is sandwiched therebetween; a device (2) that is embedded in the insulating layer (3), and in which a connection terminal non-formation surface (2c) where a connection terminal (2a) is not formed is located on a side close to the first metal layer (4); an adhesive layer (6) that is located on the connection terminal non-formation surface (2c) of the device (2); and a conductive via (7) that electrically connects the second metal layer (5) and the connection terminal (2a) of the device (2), wherein an area of the adhesive layer (6) on a surface side in contact with the device (2) is smaller than an area of the connection terminal non-formation surface (2c) of the device (2).

## Description

### Technical Field

The present invention relates to a device embedded substrate in which an electrical or electronic device is embedded, and a manufacturing method thereof.

### Background Art

Conventionally, research and development has been performed for reducing a size, a thickness, and a weight, and increasing functions of various electrical and electronic equipment. Particularly, in consumer products such as mobile phones, notebook computers, and digital cameras, there is a strong demand for the reduction in size, thickness, and weight while increasing functions. Also, in various types of electrical and electronic equipment, a frequency and a speed of a transmission signal have been increased, and it is also required to prevent a corresponding increase in signal noise.

In order to meet such demands, a device embedded substrate having a structure in which various electrical or electronic devices, which have been conventionally mounted on a substrate surface, are embedded in an insulating base material that is an insulating layer of a substrate, and a device embedded multilayer circuit board obtained by laminating the device embedded substrates have been conventionally researched, developed, and manufactured as a circuit board incorporated in electrical and electronic equipment. For example, Patent Document 1 discloses a device embedded substrate and a manufacturing method thereof.

In the method for manufacturing a device embedded substrate disclosed in Patent Document 1, a conductive thin film layer made of a copper foil is formed on a support body, and an adhesive is applied onto the conductive thin film layer. Subsequently, an electrical or electronic device to be embedded (an embedded device) is mounted via the adhesive, and an insulating layer (an insulating base material) is then formed so as to cover the embedded device. In the device embedded substrate formed through manufacturing steps as described above, a thickness of the substrate itself is smaller than that of a conventional device embedded substrate, and more electrical or electronic devices can be embedded than those mounted on a substrate surface. Thus, the device embedded substrate can be used for electrical and electronic equipment for various purposes.

Also, in a case in which an IC device such as a metaloxide-semiconductor field-effect transistor (MOSFET) or an integrated circuit (IC) is used as the embedded device, it is necessary to form a conductive via that extends to the embedded device from an outer portion of an insulating layer in which the embedded device is embedded. The conductive via extends within the insulating layer so as to penetrate metal layers formed on both surfaces of the insulating layer and an adhesive made of an insulating material for fixing the embedded device to the metal layer, and electrically connect the outer portion of the insulating layer to a connection terminal of the embedded device.

### Prior Art Document

### Patent Document

Patent Document 1: Japanese Patent No. 4874305

### Summary of the Invention

### Problems to be solved by the Invention

In recent years, since there exist a variety of types of electrical and electronic equipment, a variety of types of device embedded substrates have been developed corresponding to the types of the electrical and electronic equipment. For example, a device embedded substrate in which a plurality of IC devices are embedded in an insulating layer, and a device embedded substrate in which one IC device is embedded in an insulating layer have been developed. Here, in a case in which only one IC device is embedded, it is necessary to decrease the insulating layer such that the IC device occupies a large portion of the device embedded substrate in order to reduce a size of the device embedded substrate. In order to surely fix the IC device to a metal layer, a formation area of an adhesive layer becomes equal to or larger than an area of a mounting surface of the IC device.

However, if the formation area of the adhesive layer is increased, a pressure applied to the adhesive layer in a vacuum heating step after forming the metal layer is increased, while a stress is applied to an insulating material forming the insulating layer in a direction different from that of the pressure due to a cure shrinkage. Thus, the metal layer is detached from a support body. Due to the detachment of the metal layer as described above, wrinkles are induced in the metal layer, and reliability of the device embedded substrate itself is deteriorated.

Here, it is considered that generation of the above wrinkles can be suppressed by decreasing the formation area of the adhesive layer. However, the adhesive layer and the insulating layer having different properties are located in a region where the conductive via is formed, and there occurs a problem that materials forming the respective layers remain due to a difference in etching rate when the conductive via is formed, thereby causing a connection failure of the conductive via.

The present invention has been made in view of the problems as described above, and an object of the present invention is to provide a device embedded substrate in which a metal layer located on an insulating layer is not detached, and a connection failure of a conductive via is not caused, and a manufacturing method thereof.

### Means for Solving the Problems

In order to achieve the above object, a device embedded substrate of the present invention includes: an insulating layer that is made of an insulating material; a first metal layer and a second metal layer that are formed such that the insulating layer is sandwiched therebetween; an electrical or electronic device that is embedded in the insulating layer, and in which a connection terminal non-formation surface where a connection terminal is not formed is located on a side close to the first metal layer; an adhesive layer that is embedded in the insulating layer, and is located on the connection terminal non-formation surface of the device; and a conductive via that extends within the insulating layer, and electrically connects the second metal layer and the connection terminal of the device, wherein an area of the adhesive layer on a surface side in contact with the device is smaller than an area of the connection terminal non-formation surface of the device.

In the above device embedded substrate, the area of the adhesive layer on the surface side in contact with the device is preferably within a range of 13% to 40% of the area of the connection terminal non-formation surface of the device.

In any of the above device embedded substrate, the area of the adhesive layer on the surface side in contact with the device is preferably within a range of 7% to 25% of an area of the device embedded substrate on a surface side where the first metal layer is formed.

In any of the above device embedded substrate, a plane shape of the adhesive layer is preferably a circular shape.

Also, in order to achieve the above object, a method for manufacturing a device embedded substrate of the present invention includes: a preparation step of preparing a support plate where a first metal layer is formed on a surface; a mounting step of mounting an electrical or electronic device on a surface of the first metal layer via an adhesive layer such that a connection terminal non-formation surface where a connection terminal is not formed is located on a side close to the first metal layer; an insulating layer formation step of forming an insulating layer in which the device is embedded by laminating an insulating material so as to cover the first metal layer and the device; a metal layer formation step of forming a second metal layer on the insulating layer; and a conductive via formation step of forming a conductive via that extends within the insulating layer so as to electrically connect the second metal layer and the connection terminal of the device, wherein in the mounting step, an area of the adhesive layer on a surface side in contact with the device is made smaller than an area of the connection terminal non-formation surface of the device.

In the mounting step in the above method for manufacturing a device embedded substrate, the area of the adhesive layer on the surface side in contact with the device is preferably set to 13% to 40% of the area of the connection terminal non-formation surface of the device.

In the mounting step in any of the above method for manufacturing a device embedded substrate, the area of the adhesive layer on the surface side in contact with the device is preferably set to 7% to 25% of an area of the device embedded substrate on a surface side where the first metal layer is formed.

In the mounting step in any of the above method for manufacturing a device embedded substrate, the adhesive layer is preferably formed such that a plane shape of the adhesive layer is a circular shape.

### Advantageous Effects of the Invention

In the device embedded substrate and the manufacturing method according to the present invention, since the connection terminal non-formation surface of the device is arranged close to the first metal layer, and the formation area of the adhesive layer is made smaller than the area of the connection terminal non-formation surface of the device, it is possible to prevent detachment of the first metal layer from the insulating layer, and a connection failure of the conductive via.

In the device embedded substrate and the manufacturing method according to the present invention, since the circular shape is employed as the plane shape of the adhesive layer, bubbles, air gaps or the like are not generated in the adhesive layer when the adhesive layer is formed, and the device can be firmly fixed.

### Brief Description of the Drawings

FIG. 1 is a schematic sectional view of a device embedded substrate according to an embodiment of the present invention.
FIG. 2 is a schematic sectional view in each manufacturing step of a method for manufacturing a device embedded substrate according to the embodiment of the present invention.
FIG. 3 is a schematic sectional view in each manufacturing step of the method for manufacturing a device embedded substrate according to the embodiment of the present invention.
FIG. 4 is a schematic sectional view in each manufacturing step of the method for manufacturing a device embedded substrate according to the embodiment of the present invention.
FIG. 5 is a schematic sectional view in each manufacturing step of the method for manufacturing a device embedded substrate according to the embodiment of the present invention.
FIG. 6 is a schematic sectional view in each manufacturing step of the method for manufacturing a device embedded substrate according to the embodiment of the present invention.
FIG. 7 is a schematic sectional view in each manufacturing step of the method for manufacturing a device embedded substrate according to the embodiment of the present invention.

### Mode for Carrying out the Invention

In the following, an exemplary embodiment of the present invention is described in detail based on an embodiment by reference to the drawings. Note that the present invention is not limited to contents described below, and can be optionally modified and carried out without departing from the scope. Also, in the drawings used for describing the embodiment, all of which schematically show a device embedded substrate and its constituent members according to the present invention, the device embedded substrate and the constituent members are partially emphasized, enlarged, reduced, or omitted for the purpose of developing an understanding. Thus, the drawings do not accurately show scales, shapes or the like of the device embedded substrate and the constituent members in some cases. Furthermore, various numerical values used in the embodiment are merely examples, and can be variously changed if necessary.

### <Embodiment>

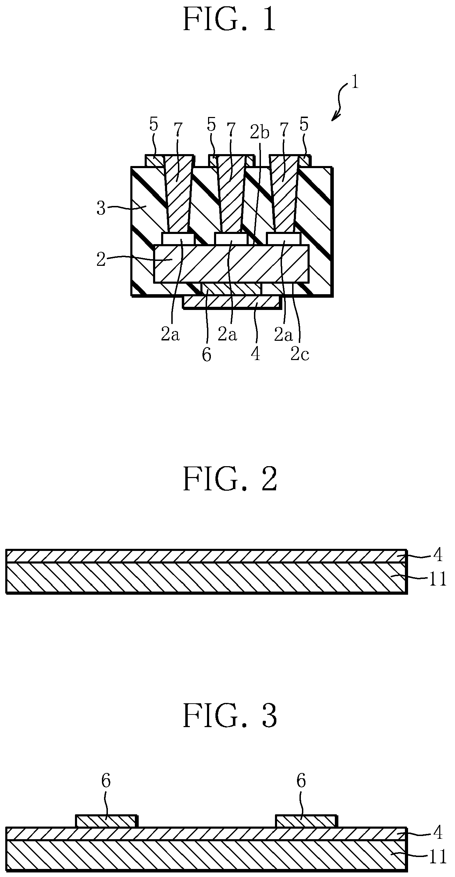

First, a structure of a device embedded substrate according to the present embodiment of the present invention is described in detail by reference to FIG 1. Here, FIG. 1 is a sectional view of the device embedded substrate according to the embodiment.

As shown in FIG. 1, a device embedded substrate 1 according to the present embodiment includes an IC device 2 that is a general electrical or electronic device, an insulating layer 3 that is formed such that the IC device 2 is embedded therein, a first metal layer 4 and a second metal layer 5 that are formed such that the insulating layer 3 is sandwiched therebetween, an adhesive layer 6 that fixes the IC device 2 onto the first metal layer 4, and a conductive via 7 that extends within the insulating layer 3 to electrically connect the second metal layer 5 and the IC device 2. Also, a dimension of the device embedded substrate 1 according to the present embodiment is about 4 mm square, and a thickness is about 0.4 mm.

The IC device 2 includes a connection terminal 2a that electrically connects an inner portion and an outer portion of the IC device 2 so as to guide a power, a current, a voltage, or an electrical signal supplied from the outer portion to the inner portion of the IC device 2 on a first surface 2b (a connection terminal formation surface)-side. Also, in the IC device 2, the connection terminal 2a is not formed on a second surface 2c located on an opposite side to the first surface 2b. That is, the second surface 2c is a connection terminal non-formation surface. Moreover, as shown in FIG. 1, the IC device 2 is embedded in the insulating layer 3 such that the second surface 2c where the connection terminal is not formed is located on a side close to the first metal layer 4. That is, in the present embodiment, the IC device 2 is embedded in a so-called face-up state. A dimension of the IC device 2 in the present embodiment is about 3.4 mm square, and a thickness is about 0.2 mm.

Although the IC device 2 is employed as a device embedded in the device embedded substrate 1 in the present embodiment, the device embedded in the device embedded substrate 1 is not limited thereto. For example, another electrical or electronic device such as a resistor and a capacitor may be embedded in the insulating layer 3.

In the present embodiment, an insulating resin material such as a prepreg is used for the insulating layer 3. Here, a material of the insulating layer 3 preferably has a thermal expansion coefficient close to that of the IC device 2. This is to mitigate a stress on the IC device 2 when the insulating material is cured. Note that the material of the insulating layer 3 is not limited to the insulating resin material, and as long as the IC device 2 can be embedded and there is no problem in electrical properties and reliability etc., another general insulating material may be used.

The first metal layer 4 is formed on a surface of the insulating layer 3 that is close to the second surface 2c of the IC device 2. In the present embodiment, the first metal layer 4 is made of copper. Also, a desired interconnection pattern is formed in the first metal layer 4 by patterning. Note that a material of the first metal layer 4 is not limited to the copper, and as long as there is no problem in electrical properties and reliability etc., another general metal material may be used.

The second metal layer 5 is formed on a surface of the insulating layer 3 that is located on an opposite side to the surface close to the second surface 2c of the IC device 2. In the present embodiment, the second metal layer 5 is made of copper similarly to the first metal layer 4. Also, a desired interconnection pattern is formed in the second metal layer 5 by patterning. Note that a material of the second metal layer 5 is not limited to the copper, and as long as there is no problem in electrical properties and reliability etc., another general metal material may be used.

In the present embodiment, an adhesive made of a general insulating material is used for the adhesive layer 6. As shown in FIG. 1, the adhesive layer 6 is formed on the second surface 2c of the IC device 2, and is also in contact with the first metal layer 4.

Also, the adhesive layer 6 is formed so as to be fitted within the second surface 2c of the IC device 2. That is, an area of the adhesive layer 6 on a surface side in contact with the IC device 2 (an application area of the adhesive) is smaller than an area of the second surface 2c of the IC device 2. To be more specific, the area of the adhesive layer 6 on the surface side in contact with the IC device 2 is preferably within a range of 13% to 40% of the area of the second surface 2c of the IC device 2. In the present embodiment, an application dimension of the adhesive is about φ1.5 mm, and the area (about 1.77 mm²) of the adhesive layer 6 on the surface side in contact with the IC device 2 is about 15% of the area (about 11.56 mm²) of the second surface 2c of the IC device 2. Although the adhesive layer 6 having a circular plane shape is formed by setting the application dimension of the adhesive to about φ1.5 mm in the present embodiment, the plane shape of the adhesive layer is not limited to the circular shape, and a polygonal shape or an elliptical shape may be employed.

Furthermore, when compared with the device embedded substrate 1 itself, the area of the adhesive layer 6 on the surface side in contact with the IC device 2 is preferably within a range of 7% to 25% of an area of the device embedded substrate 1 on a surface side where the first metal layer 4 is formed. In the present embodiment, the area of the adhesive layer 6 on the surface side in contact with the IC device 2 is about 10% of the area (about 16 mm²) of the device embedded substrate 1 on the surface side where the first metal layer 4 is formed.

By forming the adhesive layer 6 as described above, a large portion of the second surface 2c of the IC device 2 is covered with the insulating layer 3. The insulating layer 3 is also located around the adhesive layer 6. That is, the adhesive layer 6 is also in an embedded state in the insulating layer 3.

The conductive via 7 is provided to extend within the insulating layer 3 in order to electrically connect each of the connection terminals 2a of the IC device 2 and the second metal layer 5. A conductor such as copper is used as a material of the conductive via 7. Note that the material of the conductive via 7 is not limited to the copper, and as long as there is no problem in electrical properties and reliability etc., another general metal material may be used.

Next, a method for manufacturing a device embedded substrate according to the embodiment of the present invention is described in detail by reference to FIGS. 2 to 7. FIGS. 2 to 7 are schematic sectional views in respective manufacturing steps of the method for manufacturing a device embedded substrate according to the present embodiment.

First, as shown in FIG. 2, a preparation step of preparing a support plate 11 is performed. To be more specific, by forming the first metal layer 4 on the support plate 11 having stiffness, the support plate 11, a surface of which is covered with the first metal layer 4, is prepared. As the support plate 11, a plate having stiffness required in process conditions is used. For example, the support plate 11 may be formed of an SUS (stainless steel) plate or an aluminum plate having stiffness. As described above, in the present embodiment, the first metal layer 4 is made of copper. As a specific method for forming the first metal layer 4, for example, a method for forming the first metal layer 4 by depositing a copper plating when the support plate 11 is the SUS plate, or a method for forming the first metal layer 4 by attaching a copper foil when the support plate 11 is the aluminum plate can be employed.

Subsequently, as shown in FIG. 3, the adhesive layer 6 made of an insulating material is formed on the first metal layer 4, for example, by a dispenser or by printing. The adhesive layer 6 is formed at two positions on the first metal layer 4 in FIG. 3. However, in reality, a plurality of adhesive layers 6 are formed in a matrix form since a plurality of device embedded substrates 1 in each of which one IC device 2 is embedded are formed at the same time in the method for manufacturing a device embedded substrate of the present embodiment. Therefore, the number of the IC devices 2 is determined according to the number of the device embedded substrates 1 to be manufactured, and the adhesive layers 6 are formed corresponding to the number of the IC devices.

Here, in the present embodiment, the application dimension of the adhesive forming the adhesive layer 6 is set to about φ1.5 mm, and the area of the adhesive layer 6 on the surface side in contact with the IC device 2 is set to about 15% of the area of the second surface 2c of the IC device 2, and about 10% of the area of the device embedded substrate 1 on the surface side where the first metal layer 4 is formed.

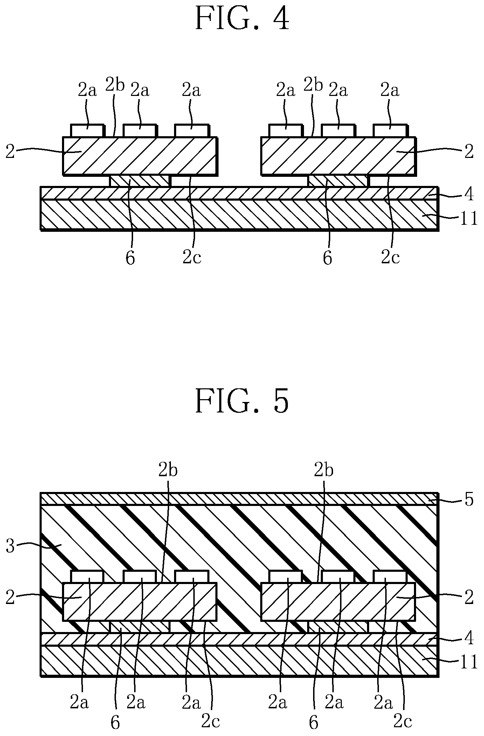

Subsequently, as shown in FIG. 4, a mounting step of mounting the IC device 2 on the first metal layer 4 via the adhesive layer 6 is performed. To be more specific, the IC device 2 that is an embedded device is mounted on the adhesive layer 6 by using a surface mounting machine (a chip mounter) including a suction nozzle. Here, the IC device 2 is mounted such that the second surface 2c where the connection terminal 2a is not formed is bonded to the adhesive layer 6, and the first surface 2b where the connection terminal 2a is formed is away from the adhesive layer 6. That is, the IC device 2 is mounted in a so-called face-up manner.

Subsequently, as shown in FIG. 5, an insulating layer formation step of forming the insulating layer 3 is performed. In the insulating layer formation step, an insulating resin material that is to become the insulating layer 3 is laminated so as to cover the IC device 2, the first metal layer 4, and the adhesive layer 6 (that is, on the IC device 2, the first metal layer 4, and the adhesive layer 6), and the IC device 2 and the adhesive layer 6 are thereby embedded in the insulating layer 3. To be more specific, the insulating layer formation step is performed by laying up an insulating resin material such as a prepreg on the IC device 2 and the adhesive layer 6, and pressing the insulating resin material while heating the insulating resin material in a vacuum. The pressing is performed by using, for example, a vacuum pressure-type press machine. Also, when the insulating layer 3 is formed, the separate second metal layer 5 is formed on the surface on the opposite side to the surface where the first metal layer 4 is located. By such a metal layer formation step, the insulating layer 3 is sandwiched between the first metal layer 4 and the second metal layer 5.

Here, in the present embodiment, the application dimension of the adhesive forming the adhesive layer 6 is set to about φ1.5 mm, and the area of the adhesive layer 6 on the surface side in contact with the IC device 2 is set to about 15% of the area of the second surface 2c of the IC device 2, and about 10% of the area of the device embedded substrate 1 on the surface side where the first metal layer 4 is formed. Thus, the insulating layer 3 covers a large portion of the second surface 2c of the IC device 2. Accordingly, a pressure applied to the adhesive layer 6 toward the first metal layer 4 when the laid-up insulating resin material such as a prepreg is heated in a vacuum becomes relatively small. Also, in the vacuum heating process, a stress caused by a cure shrinkage is applied to the insulating resin material located around the adhesive layer 6 toward the surface side where the second metal layer 5 is formed, so that the pressure and the stress cancel each other out. Accordingly, detachment of the first metal layer 4 from the support plate 11 is suppressed.

Note that a ratio of the area of the adhesive layer 6 on the surface side in contact with the IC device 2 to the area of the second surface 2c of the IC device 2 or the area of the device embedded substrate 1 on the surface side where the first metal layer 4 is formed is not limited to the above numerical value. Particularly, by setting the area of the adhesive layer 6 on the surface side in contact with the IC device 2 to be within the range of 13% to 40% of the area of the second surface 2c of the IC device 2, and to be within the range of 7% to 25% of the area of the device embedded substrate 1 on the surface side where the first metal layer 4 is formed, the above effect can be sufficiently produced.

In the present embodiment, the circular shape is employed as the plane shape of the adhesive layer 6 by setting the application dimension of the adhesive forming the adhesive layer 6 to about φ1.5 mm. Accordingly, the adhesive is properly melted, and bubbles (voids), air gaps or the like are not formed in the adhesive layer 6. Therefore, the IC device 2 can be firmly fixed onto the first metal layer 4.

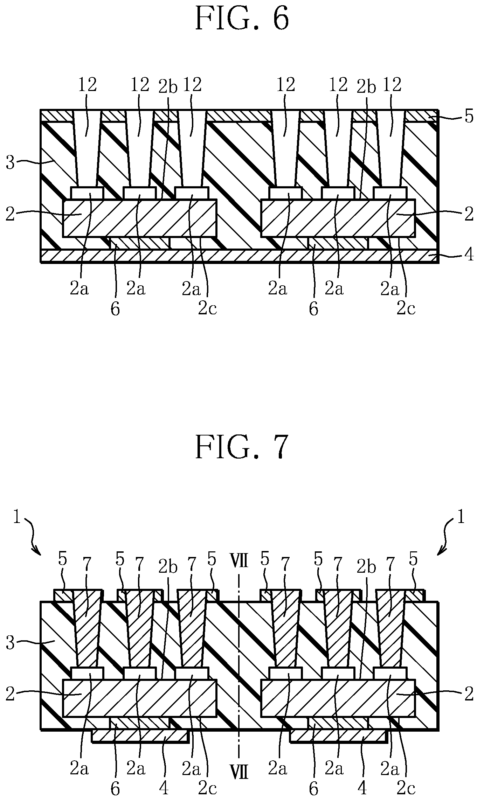

Subsequently, as shown in FIG. 6, the support plate 11 is removed, and a via 12 is formed. As a method for forming the via 12, the support plate 11 is first removed, and a via formation position is then irradiated with, for example, a CO₂ laser beam. A member in the portion irradiated with the CO₂ laser beam is thereby removed to form each via. Note that the present invention is not limited to the CO₂ laser beam, and, for example, a highfrequency laser beam such as a UV-YAG or excimer laser beam may be used. Here, the via 12 penetrates the second metal layer 5, and extends within the insulating layer 3 to reach the connection terminal 2a.

After the via 12 is formed, a desmear process is performed to remove a resin remaining in the via formation. A soft etching process is also performed on the connection terminal 2a to remove oxides and organic matters on an exposed surface of the connection terminal 2a exposed by the via formation. Accordingly, a fresh metal surface is exposed, and adhesion with metal deposited in a subsequent plating process is improved, resulting in an improvement in electrical connection reliability.

Here, around the connection terminal 2a where the via 12 is formed, only the insulating layer 3 made of the insulating resin material exists, and insulating resin materials having different properties from each other do not exist. Therefore, remaining of the insulating resin materials due to a difference in etching rate, which occurs when a via is formed in the insulating resin materials having different properties from each other, does not occur in an etching process performed when the via 12 is formed in the present embodiment. Accordingly, the device embedded substrate 1 that is finally obtained has excellent electrical properties and reliability with no connection failure of the conductive via 7 being caused.

Subsequently, as shown in FIG. 7, the conductive via 7 is formed by filling a conductor into the via 12, and patterning of the first metal layer 4 and the second metal layer 5 is performed. To be more specific, the conductive via 7 is formed by performing a plating process of a chemical copper plating, an electrolytic copper plating, or the like on the via 12 after performing a desmear or half etching process, and depositing a plating on the via 12 to fill the conductor. An etching process is further performed on the first metal layer 4 and the second metal layer 5 arranged on the both surfaces of the insulating layer 3.

By cutting the insulating layer 3 along a dashed line VII-VII in FIG. 7, the divided plurality of device embedded substrates 1 are formed. The insulating layer 3 is cut by a dividing process using a general dicing apparatus.

As described above, the device embedded substrate 1 and the manufacturing method according to the present embodiment are featured in that the second surface 2c that is the connection terminal non-formation surface of the IC device 2 is arranged close to the first metal layer 4, and the application area of the adhesive that becomes the adhesive layer 6 is made smaller than the area of the second surface 2c of the IC device 2. Because of the configuration, in the device embedded substrate 1 according to the present embodiment, the first metal layer 4 located on the surface of the insulating layer 3 is not detached, and the connection failure of the conductive via 7 is not caused.

### Explanation of Reference Signs

- 1: Device embedded substrate
- 2: IC device
- 2a: Connection terminal
- 2b: First surface
- 2c: Second surface
- 3: Insulating layer
- 4: First metal layer
- 5: Second metal layer
- 6: Adhesive layer
- 7: Conductive via
- 11: Support plate
- 12: Via

## Claims

1. A device embedded substrate comprising:
an insulating layer that is made of an insulating material;
a first metal layer and a second metal layer that are formed such that the insulating layer is sandwiched therebetween;
an electrical or electronic device that is embedded in the insulating layer, and in which a connection terminal non-formation surface where a connection terminal is not formed is located on a side close to the first metal layer;
an adhesive layer that is embedded in the insulating layer, and is located on the connection terminal non-formation surface of the device; and
a conductive via that extends within the insulating layer, and electrically connects the second metal layer and the connection terminal of the device,
wherein an area of the adhesive layer on a surface side in contact with the device is smaller than an area of the connection terminal non-formation surface of the device.

2. The device embedded substrate according to claim 1, wherein the area of the adhesive layer on the surface side in contact with the device is 13% to 40% of the area of the connection terminal non-formation surface of the device.

3. The device embedded substrate according to claim 1 or 2, wherein the area of the adhesive layer on the surface side in contact with the device is 7% to 25% of an area of the device embedded substrate on a surface side where the first metal layer is formed.

4. The device embedded substrate according to any one of claims 1 to 3, wherein a plane shape of the adhesive layer is a circular shape.

5. A method for manufacturing a device embedded substrate comprising:
a preparation step of preparing a support plate where a first metal layer is formed on a surface;
a mounting step of mounting an electrical or electronic device on a surface of the first metal layer via an adhesive layer such that a connection terminal non-formation surface where a connection terminal is not formed is located on a side close to the first metal layer;
an insulating layer formation step of forming an insulating layer in which the device is embedded by laminating an insulating material so as to cover the first metal layer and the device;
a metal layer formation step of forming a second metal layer on the insulating layer; and
a conductive via formation step of forming a conductive via that extends within the insulating layer so as to electrically connect the second metal layer and the connection terminal of the device,
wherein in the mounting step, an area of the adhesive layer on a surface side in contact with the device is made smaller than an area of the connection terminal non-formation surface of the device.

6. The method for manufacturing a device embedded substrate according to claim 5, wherein in the mounting step, the area of the adhesive layer on the surface side in contact with the device is set to 13% to 40% of the area of the connection terminal non-formation surface of the device.

7. The method for manufacturing a device embedded substrate according to claim 5 or 6, wherein in the mounting step, the area of the adhesive layer on the surface side in contact with the device is set to 7% to 25% of an area of the device embedded substrate on a surface side where the first metal layer is formed.

8. The method for manufacturing a device embedded substrate according to any one of claims 5 to 7, wherein in the mounting step, the adhesive layer is formed such that a plane shape of the adhesive layer is a circular shape.
